# EUROPEAN PATENT APPLICATION

(11) **EP 2 670 053 A1**
(43) Date of publication of application: **04.12.2013**
(21) Application number: 11856753.6
(22) Date of filing: 03.05.2011
(51) Int. Cl.: H04B 1/38, H04M 1/02, H05K 5/02

(54) **CASE FOR A MOBILE TERMINAL**

(30) Priority: 24.01.2011 KR 20110000662 U
(71) Applicant: Lee, Seung Hoon, Chungcheongnam-Do 331-839 (KR)
(72) Inventor: Lee, Seung Hoon, Chungcheongnam-Do 331-839 (KR)
(74) Representative: Beetz & Partner
(86) International application number: PCT/KR2011/003303
(87) International publication number: WO 2012/102440

(57) **Abstract**

A case for a mobile terminal includes a body disposed to overlap side surfaces and a rear surface of a mobile terminal and press-fitted onto the side surfaces, and a ring coupled to a surface of the body disposed to overlap the rear surface of the mobile terminal and having a pair of ring sections into which a user's middle finger and ring finger are inserted.

Accordingly, in a state in which the body is coupled to the mobile terminal, a user inserts his/her middle finger and ring finger of one hand into the ring to grip the mobile terminal and manipulates a liquid crystal screen having a keypad or touchscreen function using a thumb or an index finger of the one hand, enabling use of the mobile terminal with the one hand.

## Description

### [Technical Field]

The present invention relates to a case for a mobile terminal, and more particularly, to a case for a mobile terminal disposed to overlap side surfaces and a rear surface of a mobile communication terminal such as a mobile phone, a personal digital assistant (PDA), or the like, such that a user can grip the mobile terminal with one hand and manipulate a liquid crystal screen, a keypad, or the like, of the mobile terminal with fingers of the hand.

### [Background Art]

In general, a mobile terminal is a device, for example, a mobile communication device or display such as a mobile phone, a PDA, a PMP, or the like, which provides various functions such as use of the Internet, a telephone conversation, a movie appreciation, and so on, while moving and using a wireless communication network or a program stored therein.

In recent times, a tablet pad, a touch phone, a smartphone, and so on, manipulations of which become possible through touches with screens thereof, are released.

Among such mobile terminals, a smartphone or the like, which is released in recent times, has various functions such as reception and transmission of calls or text messages, document works, use of the Internet, reception and transmission of E-mails, and so on.

Accordingly, as the mobile terminal is used regardless of places and times, many people complain pains of a wrist, a shoulder, the neck, or the like. This is because the mobile terminal should be used with two hands due to restrictions of body actions.

### [Summary of Invention]

### [Technical Problem]

In order to solve the problems, an object of the present invention is to provide a case for a mobile terminal capable of using a mobile terminal with one hand.

### [Solution to Problem]

In order to achieve the aforementioned object, a case for a mobile terminal of the present invention includes: a body disposed to overlap side surfaces and a rear surface of a mobile terminal and press-fitted onto the side surfaces; and a ring coupled to a surface of the body disposed to overlap the rear surface of the mobile terminal and having a pair of ring sections into which a user's middle finger and ring finger are inserted.

The ring may be coupled to be rotatable with respect to the body.

The ring may be hinged to the body, and the body may have a ring hole having the same shape as the ring such that the ring is rotated and inserted into the body.

### [Advantageous Effects of Invention]

According to the case for a mobile terminal of the present invention, in a state in which the body is coupled to the mobile terminal, a user inserts his/her middle finger and ring finger of one hand into rings to grip the mobile terminal, and manipulates a liquid crystal screen having a keypad or touchscreen function using a thumb or an index finger of the hand, enabling use of the mobile terminal with the one hand.

### [Brief Description of Drawings]

FIG. 1 is a perspective view schematically showing a case for a mobile terminal according to a first embodiment of the present invention;
FIG. 2 is a perspective view schematically showing the case for a mobile terminal of FIG. 1 coupled to a mobile phone;
FIG. 3 is a perspective view schematically showing a case for a mobile terminal according to a second embodiment of the present invention; and
FIG. 4 is a perspective view schematically showing the case for a mobile terminal of FIG. 3 coupled to a mobile phone.

### [Description of Embodiments]

Hereinafter, a case for a mobile terminal according to an embodiment of the present invention will be described with reference to the accompanying drawings.

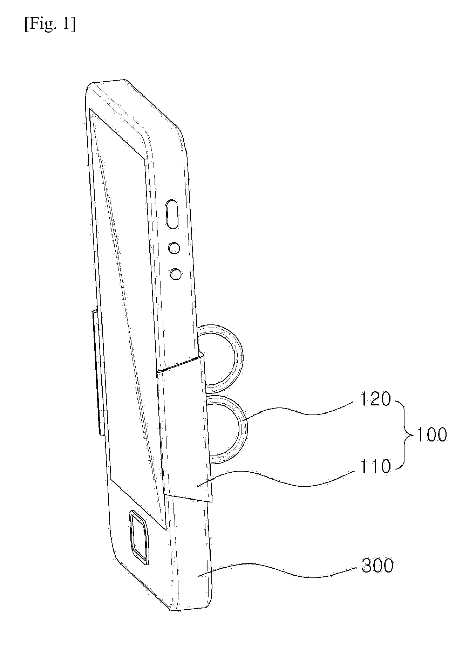

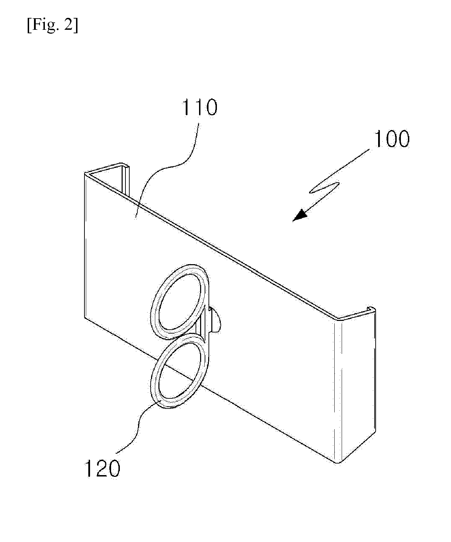

FIG. 1 is a perspective view schematically showing a case for a mobile terminal according to a first embodiment of the present invention, and FIG. 2 is a perspective view schematically showing the case for a mobile terminal of FIG. 1 coupled to a mobile phone.

Referring to FIGS. 1 and 2, a case 100 for a mobile terminal of the present invention includes a body 110 formed of a synthetic resin material or a rubber material, and a ring 120.

The body 110 has a front surface disposed to overlap a rear surface of a mobile terminal 300, and side surfaces formed at both ends of the front surface in a direction substantially perpendicular to the front surface and disposed to overlap side surfaces of the mobile terminal 300 to be coupled to the mobile terminal 300.

The body 110 has an appropriate elasticity like a conventional case of the mobile terminal 300 to be press-fitted onto the mobile terminal 300.

A hole (not shown) is formed at a center of the front surface of the body 110.

The ring 120 has a pair of circular finger insertion sections, a connecting section formed between the finger insertion sections and parallel to the body 110 and inserted into the hole of the body 110, and a support section perpendicular to the connecting section.

The finger insertion sections are portions, into which a middle finger and a ring finger of a user are inserted, have a shape substantially like glasses, and are disposed at one side of the front surface with respect to the hole formed in the body 110.

Here, while the middle finger and ring finger of the user are inserted into the finger insertion sections, it is not limited thereto and two fingers of the user may be arbitrarily inserted thereinto.

The connecting section is disposed to pass through the hole of the body 110.

The support section is disposed at the other side of the front surface of the body 110.

The ring 120 is rotatably coupled to the body 110 in consideration of the fact that a screen displayed on the mobile terminal 300 is automatically rotated in a vertical or horizontal direction as technology is developed in recent times. In a state in which the fingers are inserted into the finger insertion sections of the ring 120, the ring 120 can be rotated with respect to the body 110 to see the screen when the mobile terminal 300 is seen in the vertical direction or the horizontal direction.

According to the case 100 for a mobile terminal having the above-mentioned structure, in a state in which the body 110 is coupled to the mobile terminal 300, a user inserts his/her middle finger and ring finger of one hand into the ring 120 to grip the mobile terminal 300 and manipulates a liquid crystal screen having a keypad or touchscreen function using a thumb or an index finger of the one hand, enabling use of the mobile terminal 300 with the one hand.

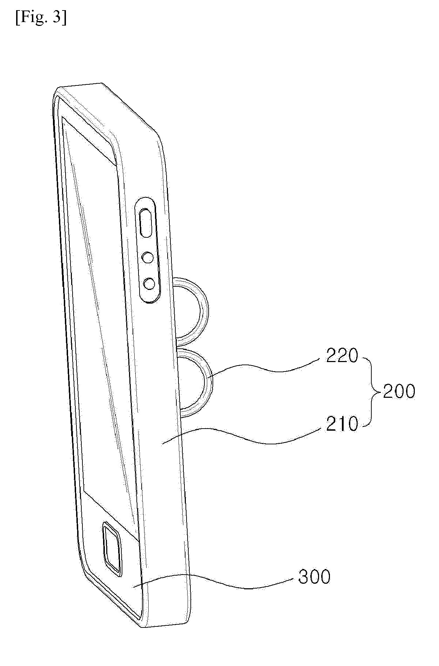

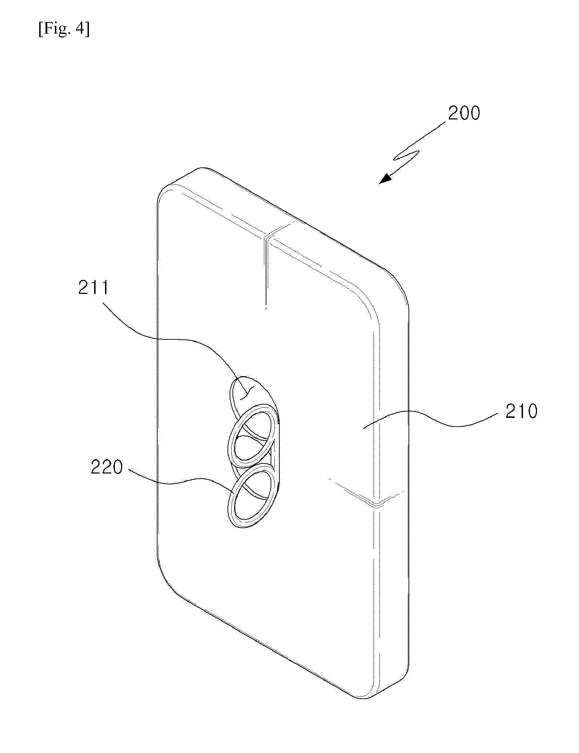

FIG. 3 is a perspective view schematically showing a case for a mobile terminal according to a second embodiment of the present invention, and FIG. 4 is a perspective view schematically showing the case for a mobile terminal of FIG. 3 coupled to a mobile phone.

Description of the same components and the same effects of the second embodiment as those of the first embodiment will not be repeated.

Referring to FIGS. 3 and 4, a case 200 for a mobile terminal of the present invention includes a body 210 and a ring 220.

The body 210 has the same shape as the mobile terminal 300, and a front surface thereof is opened to expose the front surface of the mobile terminal 300, on which a screen is disposed.

A ring hole 211 is formed at a center of a rear surface of the body 210 disposed to overlap the rear surface of the mobile terminal 300.

The ring hole 211 has the same shape as the ring 220 or a larger size than the ring 220 such that the ring 220 is accommodated in the ring hole 211 when the ring 220 is disposed to overlap the ring hole 211.

The ring 220 has a pair of finger insertion sections into which a user's fingers are inserted, and a connecting section configured to connect the pair of finger insertion sections. The connecting section may be hinged to be rotatable with respect to the body 210 so that the ring 220 can be rotated and inserted into the ring hole 211.

Accordingly, the ring 220 is normally inserted into the ring hole 211 to prevent interference with the ring 220.

According to the case 200 for a mobile terminal having the above-mentioned structure, in a state in which the body 210 is coupled to the mobile terminal 300, a user inserts his/her middle finger and ring finger of one hand into the ring 220 to grip the mobile terminal 300 and manipulates a liquid crystal screen having a keypad or touchscreen function using a thumb or an index finger of the one hand, enabling use of the mobile terminal 300 with the one hand.

## Claims

1. A case for a mobile terminal comprising:
a body disposed to overlap side surfaces and a rear surface of a mobile terminal and press-fitted onto the side surfaces; and
a ring coupled to a surface of the body disposed to overlap the rear surface of the mobile terminal and having a pair of ring sections into which a user's middle finger and ring finger are inserted,
wherein the ring is coupled to be rotatable with respect to the body.

2. A case for a mobile terminal comprising:
a body disposed to overlap side surfaces and a rear surface of a mobile terminal and press-fitted onto the side surfaces; and
a ring coupled to a surface of the body disposed to overlap the rear surface of the mobile terminal and having a pair of ring sections into which a user's middle finger and ring finger are inserted,
wherein the ring is hinged to the body, and the body has a ring hole having the same shape as the ring such that the ring is rotated and inserted into the body.
